# EUROPEAN PATENT SPECIFICATION

(11) **EP 4 421 507 B1**
(45) Date of publication and mention of the grant of the patent: **25.06.2025**
(21) Application number: 23158263.6
(22) Date of filing: 23.02.2023
(51) Int. Cl.: G01R 31/54, F03D 80/30, G01R 31/58

(54) **SIGNAL-INJECTION DEVICE AND METHOD FOR A LIGHTNING PROTECTION SYSTEM OF A WIND TURBINE**
SIGNALEINSPEISUNGSVORRICHTUNG UND VERFAHREN FÜR EIN BLITZSCHUTZSYSTEM EINER WINDENERGIEANLAGE
DISPOSITIF D'INJECTION DE SIGNAL ET PROCÉDÉ POUR UN SYSTÈME DE PROTECTION CONTRE LA FOUDRE D'UNE ÉOLIENNE

(43) Date of publication of application: 28.08.2024
(73) Proprietor: Polytech A/S, 6740 Bramming (DK)
(72) Inventor: VOGEL, Stephan, 2300 Copenhagen (DK); MADSEN, Søren Find, 4330 Hvalsø (DK); KIEL JENSEN, Ole, 9220 Aalborg (DK); FRANEK, Ondrej, 9220 Aalborg (DK); FRØLUND PETERSEN, Gert, 9220 Aalborg (DK)
(74) Representative: Zacco Denmark A/S

(56) References cited:
- JP-A- 2021 025 859
- JP-B2- 5 971 673
- US-A- 5 929 625
- US-B2- 10 615 584

## Description

The present invention relates to a device and a method for injecting electrical probe signals into a lightning protection system of a wind turbine or a part thereof, in particular a wind turbine blade, and to a device and a method for monitoring the condition of the lightning protection system.

### Background of the invention

Lightning protection systems of wind turbine blades are usually physical electrical conductors embedded in the structure of the blade. These conductors are typically routed inside the blade and/or are integrated in the shell of the blade.

The integrity of a lightning protection system of a wind turbine is traditionally validated with a direct current (DC) continuity measurement between the external receptors of the blade and the blade root. These measurements are typically done after manufacturing, after installation and typically repeated every one to two years during operation of the turbine.

However, a DC continuity measurement can be misleading as predominantly the path of least resistance determines the result of such a measurement. In case the lightning protection system is characterized by several parallel conductive elements (typically the case, e.g., in carbon fibre reinforced polymer blades or for blades with additional conductive components equi-potentialised to the down conductor), a fault is likely not detected and the blade is in the risk of being severely damaged by the next lightning attachment.

Moreover, a DC continuity measurement is labour extensive, governed by HSE (health, safety and/or environment) issues and comparatively slow, as it requires a rope-access from outside of a wind turbine blade. A person needs to rappel down a blade and connect the DC measurement equipment to the outside of the receptors at the tip of the blade to validate whether there is an electrical continuity to the root end of the lightning protection system or not.

These measurements are therefore considered rather time-consuming and complex, inflexible and expensive. In addition, they may only take place at discrete single intervals, so that damage that occurs a short time after the last measurement potentially remains unnoticed for a longer period.

In an attempt to overcome these disadvantages, it has been found that such monitoring may be realized by injecting high-frequency probe signals into the lightning protection system and other electrically conductive components of the wind turbine blade and subsequently analysing the response signal returned by the lightning protection system.

The document US 10 615 584 B2 discloses the application of variable frequency test signals to the lightning protection system of a wind turbine.

The use of such high-frequency probe signals makes it possible to detect a status or changes of the status of the lightning protection system via impedance characteristics of the lightning protection system. A corresponding signal processing can therefore rely on travelling wave and reflection theory, as well as an analysis of resonance points. Hence, measurement quality and information that is obtainable with this technique is drastically enhanced compared to common DC measurement techniques.

For the injected signal to have a return path, two connection terminals of the signal source are used. The first connection terminal of the signal source is typically connected to a part of the lightning protection system of the wind turbine blade, such as a down conductor, or at least a conductive part in galvanic connection therewith. The other connection terminal of the signal source is typically connected to a grounded connection, such as the grounded tower, nacelle and hub of the wind turbine structure, for providing a reference potential.

The injection of such high-frequency probe signal into the lightning protection system is, however, neither simple nor straightforward. In order to avoid that the signal source is effectively short-circuited and the probe signal magnitude is too weak for a sufficient response signal to be measured, there must be a high impedance between the two connection terminals of the signal source at the feed-in point, at which the signal is injected.

The easiest way to achieve such a high-impedance interface would be to disconnect the down conductor from the grounded reference potential and to connect the signal source in series there between. However, coupling the signal source in series with the lightning protection system would cause the current of a lightning, which was intercepted by the lightning protection system of the wind turbine blade, to be conducted from the wind turbine blade to the grounded reference point flowing through the internal impedance of the signal source. A typical signal source with an intrinsic output impedance of about 50 Ω is likely to be severely damaged by the effects of any type of lightning current.

The use of a high impedance interface at the feed-in point for the probe signal, which is needed for obtaining a sufficient response signal, cf. the above, is not unproblematic. Rather, it is a source of different risks.

Thus, there is a risk of flashover when a lightning is intercepted by the lightning protection system of the wind turbine blade because the voltage drop across the feed-in point increases with the impedance. Lightning currents can be characterised as short-duration, high-energy impulse discharges, where temperatures in arc plasmas can reach beyond 10.000 degrees Celsius, which is enough to ignite nearby composite materials. Therefore, such flashovers constitute a fire hazard as well as risks of other types of damages to the equipment.

Furthermore, the use of a high-impedance interface can also cause a build-up of charges on the lightning protection system due to electrostatic or triboelectric charging and after lightning events. Such a build-up of charges can pose risks to personnel working on wind turbines and electric equipment due to unintended discharges.

Potential solutions using a combination of spark gaps, surge protection devices and high-ohmic resistors to protect the electronic circuits have been suggested. Such solutions are expensive and they are sensitive to failure as these components need to be carefully dimensioned and well attuned.

### Brief description of the invention

In view of the foregoing, it is a purpose of the present invention to provide a solution, which overcomes the aforementioned disadvantages and allows a straightforward, reliable and operator-friendly injection of appropriate probe signals into a lightning protection system of a wind turbine or a part thereof, in particular a wind turbine blade, and thereby also a less cumbersome monitoring of the condition of such a lightning protection system.

Thus, in a first aspect of the present invention, it relates to a signal-injecting device for injecting variable-frequency electrical probe signals into a lightning protection system of a wind turbine or a part thereof without disconnecting the lightning protection system from a main grounding path galvanically connecting the lightning protection system to the ground, said signal-injecting device comprising one or more ferrite cores arranged around a protection unit, such as a down conductor, of the lightning protection system, around the main grounding path or at a connection point between the protection unit and the main grounding path and a signal source being configured to generate and inject variable-frequency electrical probe signals into the lightning protection system, the signal source being connected across the one or more ferrite cores.

The invention makes use of the inductive properties of a ferrite core. At the high probe signal frequencies, which will typically be in the high MHz range and/or in the GHz range, the ferrite core constitutes a very high impedance so that, although the lightning protection system or part thereof is not physically disconnected from the main grounding path, an electrical disconnection is obtained in practice between the two connection terminals of the signal source. The frequency contents of lightning strikes cover a wide range of frequencies, but do not exceed 1 MHz. At these much lower frequencies, the ferrite core constitutes a much lower impedance, so that lightning strikes intercepted by the lightning protection system will pass through the ferrite core almost as if it was not there.

Thus, whereas ferrite cores are normally used for blocking transient noise signals of high frequency while letting the information carrying signal pass through, it is used the other way around in the present invention, in which the information carrying probe signal from the signal source is being prevented from being short circuited, whereas the noise signal in form of the lightning strike is let through.

In an embodiment of the invention, each of the probe signals consist of a single pulse or a train of pulses, such as square pulses, Gaussian pulses or Dirac pulses, the maximum gradient of which pulse or pulses is between 10 mV/ns and 1000 V/ns, preferably between 100 mV/ns and 100 V/ns, most preferred between 1 V/ns and 10 V/ns.

The steep gradients of the pulse or pulses used ensure that the main frequency contents of the probe signals are within a range high enough to be blocked by the ferrite core(s).

In an embodiment of the invention, each of the probe signals consist of a train of pulses, the pulse repetition interval of which is between 100 ns and 10,000 ns, preferably between 500 ns and 2,000 ns.

Such repetition rates allow for collecting a large number of measurements in a very short time, which can then be averaged for obtaining a reliable estimate of the actual condition of a lightning protection system even for moving parts of a wind turbine, if the signal-injection device is used for such a purpose.

If, for instance, the pulse train contains 100 pulses with a repetition frequency of 1,000 ns, 100 datasets will be collected in 100 µs, during which period the tip of a wind turbine blade will typically not move more than about 1 cm when the wind turbine is running. This means that, in practice, the wind turbine blade can be considered to be in the same position throughout the measurement.

In an embodiment of the invention, the current and voltage amplitudes of the probe signals are between 0 A and 5 A and/or between 0 V and 50 V, respectively.

These ranges have proven to be suitable for obtaining response signals of a sufficient quality, when the signal-injection device is used in a condition-monitoring device as described below.

According to a second aspect of the invention, it relates to a condition-monitoring device for monitoring the condition of a lightning protection system of a wind turbine or a part thereof, said condition-monitoring device comprising a signal-injecting device as described above, a measuring device being configured to detect and measure electrical response signals from the lightning protection system, the measuring device being arranged in parallel with the signal source across the one or more ferrite cores, and a control unit being configured to control the function of the signal source and the measuring device and to process the response signals detected by the measuring device.

The signal-injecting device as described above has proven to be very useful for condition-monitoring lightning protection systems of a wind turbine or a part thereof, in particular a wind turbine blade, when being combined with a suitable measuring device and a control unit for controlling the signal source and the measuring device, thus forming a condition-monitoring device for monitoring the condition of a lightning protection system of a wind turbine or a part thereof.

The working principle of the condition-monitoring device is to inject pulses and/or repetitive signals with specific gradients and in specific frequency ranges defined by the gradients into a protection unit of the lightning protection system of the wind turbine. Subsequently, a signal processing of the response signals is performed (either within the condition-monitoring device and/or in a remote computing system). Thereby, the condition of the lightning protection system is determined.

With this concept, the condition of the lightning protection system can be validated continuously during the operation of the turbine. Thus, the condition of the lightning protection system can also be validated without the need of physical presence of technicians, thereby avoiding potentially dangerous rope-access operations and the like.

In addition, damages that are triggered and progressively develop over time, may be identified early by the present invention so that repairs can be initiated in due time. Repairing the lightning protection systems and other parts of a wind turbine before the damage worsen saves both repair costs and down time of the wind turbine.

The response signals comprise reflections from different impedances within the lightning protection system or a circuit comprising the lightning protection system. Thus, the response signals are characteristic for a given lightning protection systems and will change if one or more impedances within the lightning protection system change.

In an embodiment of the invention, the signal source, the measuring device and/or the control unit are physically located in a tower, a hub, a nacelle or a blade of the wind turbine, and a cable, preferably a coaxial cable, is used for connecting the signal source and/or the measuring device across the one or more ferrite cores.

For practical reasons, it has proven to be advantageous to locate the different elements of the condition-monitoring device together, preferably in a common casing or housing.

In an embodiment of the invention, the control unit is configured to communicate with at least one, in particular remote, data storage and analysing device.

Sending the data to a remote data storage and analysing device allows for analysing the data where and when it might be most convenient.

Furthermore, using a data storage and analysing device, a long term monitoring of the lightning protection system is feasible by storing a large number of response signals, e.g., over days, months or years. In particular, the response signals are stored in the data storage and analysing device in order to enable a data evaluation and comparison of different signals, e.g., for different days or under particular weather conditions. A quantitative assessment of the status of the lightning protection system can be compared across a fleet of similar blades, to provide OEMs a better understanding of the failure mechanism.

Various algorithms may be used to detect faults in the lightning protection system by analysis of the stored probe signals and response signals. Preferably, the processing is performed by the control unit and/or by the data storage and analysing device. Thereby, it is possible to locate a potential fault or a slowly degrading connection. Moreover, a fingerprint signal (e.g., from the day of installation) for a specific blade may be stored and compared with further response signals over a long term. Machine learning and artificial intelligence analysis methods may be implemented to track significant changes in the response signals, thereby mapping the changes in the conductive system of the blade. Significant changes from the original signature of the signals (during a short time instance or during a long time change) can indicate different failure modes within the blade.

In a third aspect of the invention, it relates to a condition-monitoring system for monitoring the condition of a lightning protection system of one or more parts of a wind turbine, said system comprising one or more condition-monitoring devices as described above and one or more, in particular remote, data storage and analysing devices configured to communicate with the control unit(s) of the one or more condition-monitoring devices for receiving and storing and/or analysing probe signals and/or response signals.

Combining one or more condition-monitoring devices in a condition-monitoring system makes it possible to monitor, for instance, the lightning protection systems of all the blades of a wind turbine simultaneously.

In a fourth aspect of the invention, it relates to a wind turbine comprising one or more signal-injecting devices as described above, one or more condition-monitoring devices as described above and/or a condition-monitoring system as described above.

In a fifth aspect of the invention, it relates to a method for injecting variable-frequency electrical probe signals into a lightning protection system of a wind turbine or a part thereof without disconnecting the lightning protection system from a main grounding path galvanically connecting the lightning protection system to the ground, said method comprising the steps of
a) arranging one or more ferrite cores around a protection unit, such as a down conductor, of the lightning protection system, around the main grounding path or at a connection point between the protection unit and the main grounding path,
b) connecting a signal source, which is configured to generate and inject the electrical probe signals into the lightning protection system, across the one or more ferrite cores, and
c) injecting the generated probe signals into a circuit comprising the lightning protection system and at least a part of the main grounding path by means of the signal source.

In an embodiment of the invention, the method is performed using a signal-injecting device as described above.

In a sixth aspect of the invention, it relates to a method for monitoring the condition of a lightning protection system of a wind turbine or a part thereof using one or more condition-monitoring devices as described above or a condition-monitoring system as described above, said method comprising the steps of
i) injecting variable-frequency electrical probe signals into the lightning protection system using the method as described above and
ii) measuring electrical response signals from the circuit by means of the measuring device.

In an embodiment of the invention, the method further comprises a step of storing and analysing the probe signals and the response signals, wherein the analysis is preferably based on a change of impedance of the circuit.

In an embodiment of the invention, the circuit comprises the lightning protection system(s) of one or more wind turbine blades and at least a part of the main grounding path including a conducting tower unit formed at least partly by an exterior part of a tower of the wind turbine.

In this configuration, the capacitive coupling between the blade and the conducting tower unit, especially when the blade and the tower are aligned, provides a stable and reliable return path for the probe signals injected by the signal-injecting device.

Feasibility studies have shown that a stable return path for the response signal is important for ensuring consistent results. Therefore, the measurements are performed preferably when the wind turbine blade is aligned with the tower, providing a capacitive coupling between the lightning protection system of the blade and the tower, thereby enabling the return path for the signal.

In an embodiment of the invention, the one or more condition-monitoring devices are configured to perform steps i) and ii) during operation of the wind turbine, in particular continuously, and/or wherein steps i) and/or ii) are performed every time or at regular intervals, when a wind turbine blade, the lightning protection system of which is being monitored by the respective condition-monitoring device, is aligned with the tower.

For power saving purposes, it can be chosen only to inject probe signals and/or to measure response signals in periods, in which the relevant blade is aligned with the tower and a stable and reliable return path for the probe signals are secured.

### Figures

A few exemplary embodiments of the invention will be described more in detail in the following with reference to the figures, of which
- Fig. 1: schematically illustrates an unsuitable implementation of a signal-injecting device, which is not part of the invention,
- Fig. 2: schematically illustrates the working principle of a signal-injecting device according to an aspect of the invention,
- Fig. 3: schematically illustrates the working principle of a condition-monitoring device according to an aspect of the invention,
- Fig. 4: schematically illustrates a condition-monitoring device according to an embodiment of the invention, and
- Fig. 5: schematically illustrates the working principle of a method for monitoring the condition of a lightning protection system of a wind turbine blade according to an embodiment of the invention.

### Detailed description of the invention

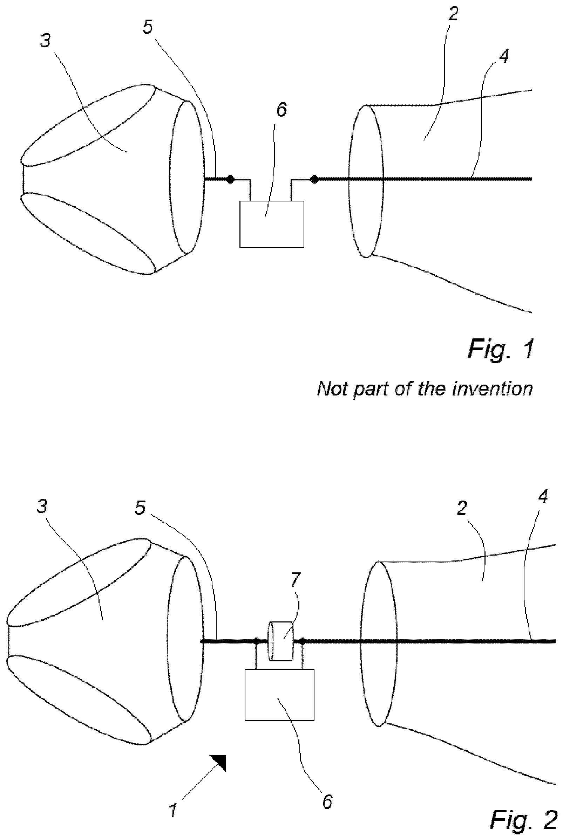

Fig. 1 schematically illustrates an unsuitable implementation of a signal-injecting device 1, which is not part of the invention. From one perspective, this would be the perfect high-impedance interface for connecting a signal source 6 of a signal-injecting device 1 as described above because there is a disconnection and, therefore, a very high impedance between the connection terminals of the signal source 6. One connection terminal of the signal source 6 is connected to a down conductor 4 of the lightning protection system of a wind turbine blade 2, and the other connection terminal of the signal source 6 is connected to a main grounding path 5, which continues through the wind turbine hub 3 and the wind turbine tower 15 (not shown in this figure) to the ground. Thus, the signal source 6 is connected in series between the down conductor 4 and the main grounding path 5.

Although being perfect, when it comes to providing a high impedance between the connection terminals of the signal source 6, this solution is unsuitable, because the signal source 6 is coupled in series with the lightning protection system. This means that, if a lightning is intercepted by the lightning protection system of the wind turbine blade 2, the lightning current will pass through the signal source 6 on its way to the ground, which will almost certainly severely damage or destroy the electronics therein.

Furthermore, the solution illustrated in Fig. 1 is difficult to use in practice, because it requires that the down conductor 4 is physically disconnected from the main grounding path 5 for the signal source 6 to be connected in series between the two, which is by no means a simple procedure.

Fig. 2 schematically illustrates the working principle of a signal-injecting device 1 according to an aspect of the invention. A ferrite core 7 is mounted at the connection point between the down conductor 4 and the main grounding path 5. In similar embodiments, the ferrite core 7 could be mounted further away from the hub 3, i.e. around the down conductor 4, or closer to the hub 3, i.e. around the main grounding path 5. The principle would be the same, the important thing being that the signal source 6 is mounted across the ferrite core 7, i.e. with a connection terminal connected on each side of the ferrite core 7.

Contrary to the solution illustrated in Fig. 1, the down conductor 4 (or part thereof) need not to be physically disconnected from the main grounding path 5 for obtaining the necessary high impedance between the connection terminals of the signal source 6 when using the present invention. Rather, this high impedance is constituted by the ferrite core 7 due to the high frequencies of the probe signal S_{P} injected into the lightning protection system of the wind turbine blade 2 by the signal source 6.

Furthermore, the lightning current of a lightning strike intercepted by the lightning protection system of the wind turbine blade 2 will pass straight through the ferrite core 7 almost as if it was not there, because the impedance of the ferrite core 7 is very low at the frequencies, which are present in a lightning strike. Thus, the impedance implied by the ferrite core 7 to the down conductor 4 is much smaller than the output impedance of the signal source 6 and, hence, very little of the energy of the lightning strike will enter into the signal source 6.

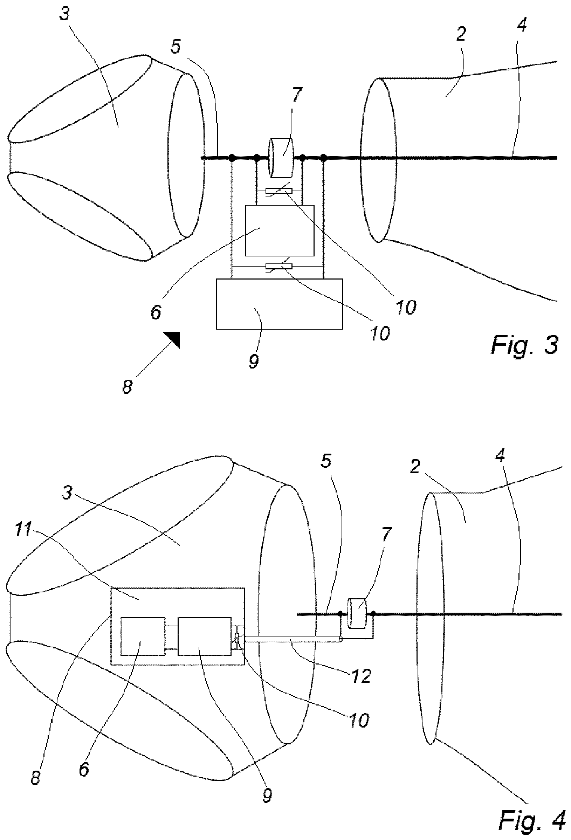

Fig. 3 schematically illustrates the working principle of a condition-monitoring device 8 according to an aspect of the invention. For obtaining a condition-monitoring device 8, the signal source 6 and the ferrite core 7 of the signal-injecting device 1 as described above have been combined with a measuring device 9 and a control unit 11 (not shown in this drawing).

The measuring device 9 is connected across the ferrite core 7, i.e. in parallel with the signal source 6 so that it is able to measure the response signals S_{R}, which are returned from the lightning protection system when probe signals S_{P} are injected therein. The control unit 11 controls the function of the signal source 6 and the measuring device 9 and makes sure that the measured response signals S_{R} are stored and/or forwarded to a, preferably remote, storage and analysing device.

Fig. 3 also shows how the signal source 6 and the measuring device 9 may be further protected from being damaged by lightning current by arranging one or more surge protections 10 between the connection terminals thereof.

Fig. 4 schematically illustrates a condition-monitoring device 8 according to an embodiment of the invention. This embodiment shows how, for practical reasons, the signal source 6, the measuring device 9 and the control unit 11 as well as one or more surge protections 10 may be arranged together, preferably in a common casing or housing at some distance from the ferrite core 7. In the illustrated embodiment, these parts are arranged within the wind turbine hub 3, but in similar embodiments, they may be arranged at other places, such as within the wind turbine blade 2 or within the wind turbine tower 15. A cable, preferably a coaxial cable 12, is used for connecting the signal source 6 and the measuring device 9 across the ferrite core 7.

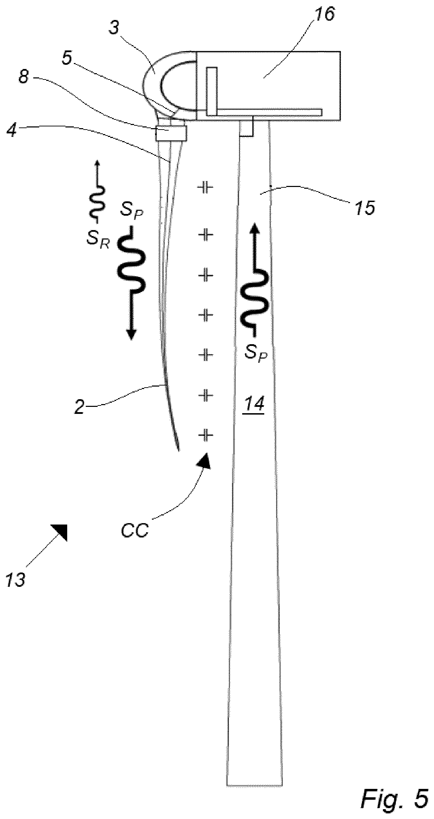

Fig. 5 schematically illustrates the working principle of a method for monitoring the condition of a lightning protection system of a wind turbine blade 2 according to an embodiment of the invention. The signal source 6 (not shown in this drawing) of a condition-monitoring device 8 arranged near the connection between a wind turbine blade 2 and the wind turbine hub 3 injects high-frequency probe signals S_{P} into the down conductor 4 of the lightning protection system of the wind turbine blade 2. A return path for the probe signals S_{P} to the signal source 6 is established through a conducting tower unit 14 due to capacitive coupling CC between the wind turbine blade 2 and the wind turbine tower 15. The conductive tower unit 14 is formed, at least partly, by the exterior part of the wind turbine tower 15, which is typically made by metal and therefore is conducting. As for the capacitive coupling CC between the wind turbine blade 2 and the wind turbine tower 15, it is obvious that it is most stable and reliable when the wind turbine blade 2 and the wind turbine tower 15 are aligned, i.e. when the wind turbine blade 2 is pointing downwards.

Fig. 5 also illustrates how response signals S_{R} return from the lightning conducting system when probe signals S_{P} are injected therein. These response signals SR are measured by the measuring device 9 (not shown in this drawing) of the condition-monitoring device 8 and stored and/or forwarded by the control unit 11 (not shown in this drawing).

### List of reference numbers

- 1.: Signal-injecting device
- 2.: Wind turbine blade
- 3.: Wind turbine hub
- 4.: Down conductor
- 5.: Main grounding path
- 6.: Signal source
- 7.: Ferrite core
- 8.: Condition-monitoring device
- 9.: Measuring device
- 10.: Surge protection
- 11.: Control unit
- 12.: Coaxial cable
- 13.: Wind turbine
- 14.: Conducting tower unit
- 15.: Wind turbine tower
- 16.: Nacelle
- SP.: Probe signal
- SR.: Response signal
- CC.: Capacitive coupling

## Claims

1. A signal-injecting device (1) for injecting variable-frequency electrical probe signals (S_{P}) into a lightning protection system of a wind turbine (13) or a part thereof without disconnecting the lightning protection system from a main grounding path (5) galvanically connecting the lightning protection system to the ground, said signal-injecting device (1) comprising
one or more ferrite cores (7) arranged around a protection unit, such as a down conductor (4), of the lightning protection system, around the main grounding path (5) or at a connection point between the protection unit and the main grounding path (5) and
a signal source (6) being configured to generate and inject variable-frequency electrical probe signals (S_{P}) into the lightning protection system, the signal source (6) being connected across the one or more ferrite cores (7).

2. The signal-injecting device (1) according to claim 1, wherein each of the probe signals (S_{P}) consist of a single pulse or a train of pulses, such as square pulses, Gaussian pulses or Dirac pulses, the maximum gradient of which pulse or pulses is between 10 mV/ns and 1000 V/ns, preferably between 100 mV/ns and 100 V/ns, most preferred between 1 V/ns and 10 V/ns.

3. The signal-injecting device (1) according to claim 2, wherein each of the probe signals (S_{P}) consist of a train of pulses, the pulse repetition interval of which is between 100 ns and 10,000 ns, preferably between 500 ns and 2,000 ns.

4. The signal-injecting device (1) according to any of the preceding claims, wherein the current and voltage amplitudes of the probe signals (S_{P}) are between 0 A and 5 A and/or between 0 V and 50 V, respectively.

5. A condition-monitoring device (8) for monitoring the condition of a lightning protection system of a wind turbine (13) or a part thereof, said condition-monitoring device (8) comprising
a signal-injecting device (1) according to any of the preceding claims,
a measuring device (9) being configured to detect and measure electrical response signals (S_{R}) from the lightning protection system, the measuring device (9) being arranged in parallel with the signal source (6) across the one or more ferrite cores (7), and
a control unit (11) being configured to control the function of the signal source (6) and the measuring device (9) and to process the response signals (S_{R}) detected by the measuring device (9).

6. The condition-monitoring device (8) according to claim 5, wherein the signal source (6), the measuring device (9) and/or the control unit (11) are physically located in a tower (15), a hub (3), a nacelle (16) or a blade (2) of the wind turbine (13), and a cable, preferably a coaxial cable (12), is used for connecting the signal source (6) and/or the measuring device (9) across the one or more ferrite cores (7).

7. The condition-monitoring device (8) according to claim 5 or 6, wherein the control unit (11) is configured to communicate with at least one, in particular remote, data storage and analysing device.

8. A condition-monitoring system for monitoring the condition of a lightning protection system of one or more parts of a wind turbine (13), said system comprising
one or more condition-monitoring devices (8) according to any of claims 5-7 and
one or more, in particular remote, data storage and analysing devices configured to communicate with the control unit(s) (11) of the one or more condition-monitoring devices (8) for receiving and storing and/or analysing probe signals (S_{P}) and/or response signals (S_{R}).

9. A wind turbine (13) comprising one or more signal-injecting devices (1) according to any of claims 1-4, one or more condition-monitoring devices (8) according to any of claims 5-7 and/or a condition-monitoring system according to claim 8.

10. A method for injecting variable-frequency electrical probe signals (S_{P}) into a lightning protection system of a wind turbine (13) or a part thereof without disconnecting the lightning protection system from a main grounding path (5) galvanically connecting the lightning protection system to the ground, said method comprising the steps of
a) arranging one or more ferrite cores (7) around a protection unit, such as a down conductor (4), of the lightning protection system, around the main grounding path (5) or at a connection point between the protection unit and the main grounding path (5),
b) connecting a signal source (6), which is configured to generate and inject the electrical probe signals (S_{P}) into the lightning protection system, across the one or more ferrite cores (7), and
c) injecting the generated probe signals (S_{P}) into a circuit comprising the lightning protection system and at least a part of the main grounding path (5) by means of the signal source (6).

11. The method according to claim 10, wherein the method is performed using a signal-injecting device (1) according to any of claims 1-4.

12. A method for monitoring the condition of a lightning protection system of a wind turbine (13) or a part thereof using one or more condition-monitoring devices (8) according to any of claims 5-7 or a condition-monitoring system according to claim 8, said method comprising the steps of
i) injecting variable-frequency electrical probe signals (S_{P}) into the lightning protection system using the method according to claim 11 and
ii) measuring electrical response signals (S_{R}) from the circuit by means of the measuring device (9).

13. The method according to claim 12, further comprising a step of storing and analysing the probe signals (S_{P}) and the response signals (S_{R}), wherein the analysis is preferably based on a change of impedance of the circuit.

14. The method according to claim 12 or 13, wherein the circuit comprises the lightning protection system(s) of one or more wind turbine blades (2) and at least a part of the main grounding path (5) including a conducting tower unit (14) formed at least partly by an exterior part of a tower (15) of the wind turbine (13).

15. The method according to claim 14, wherein the one or more condition-monitoring devices (8) are configured to perform steps i) and ii) during operation of the wind turbine (13), in particular continuously, and/or wherein steps i) and/or ii) are performed every time or at regular intervals, when a wind turbine blade (2), the lightning protection system of which is being monitored by the respective condition-monitoring device (8), is aligned with the tower (15).

## Patentansprüche

1. Signaleinspeisungsvorrichtung (1) zum Einspeisen von elektrischen Prüfsignalen (S_{P}) mit variabler Frequenz in ein Blitzschutzsystem einer Windenergieanlage (13) oder eines Teils davon, ohne das Blitzschutzsystem von einem Haupterdungspfad (5), der das Blitzschutzsystem galvanisch mit der Erde verbindet, zu trennen, wobei die Signaleinspeisungsvorrichtung (1) Folgendes umfasst:
einen oder mehrere Ferritkerne (7), die um eine Schutzeinheit, wie etwa einen Ableiter (4), des Blitzschutzsystems, um den Haupterdungspfad (5) oder an einem Verbindungspunkt zwischen der Schutzeinheit und dem Haupterdungspfad (5) angeordnet sind, und
eine Signalquelle (6), die dazu konfiguriert ist, elektrische Prüfsignale (S_{P}) mit variabler Frequenz zu erzeugen und in das Blitzschutzsystem einzuspeisen, wobei die Signalquelle (6) über den einen oder die mehreren Ferritkerne (7) verbunden ist.

2. Signaleinspeisungsvorrichtung (1) nach Anspruch 1, wobei jedes der Prüfsignale (S_{P}) aus einem einzelnen Impuls oder einer Impulsfolge besteht, wie etwa Rechteckimpulsen, Gauß-Impulsen oder Dirac-Impulsen, dessen oder deren maximaler Gradient zwischen 10 mV/ns und 1000 V/ns, bevorzugt zwischen 100 mV/ns und 100 V/ns, am meisten bevorzugt zwischen 1 V/ns und 10 V/ns liegt.

3. Signaleinspeisungsvorrichtung (1) nach Anspruch 2, wobei jedes der Prüfsignale (S_{P}) aus einer Impulsfolge besteht, deren Impulswiederholungsintervall zwischen 100 ns und 10.000 ns, bevorzugt zwischen 500 ns und 2.000 ns liegt.

4. Signaleinspeisungsvorrichtung (1) nach einem der vorhergehenden Ansprüche, wobei die Strom- und Spannungsamplituden der Prüfsignale (S_{P}) zwischen 0 A und 5 A bzw. zwischen 0 V und 50 V liegen.

5. Zustandsüberwachungsvorrichtung (8) zum Überwachen des Zustands eines Blitzschutzsystems einer Windenergieanlage (13) oder eines Teils davon, wobei die Zustandsüberwachungsvorrichtung (8) Folgendes umfasst:
eine Signaleinspeisungsvorrichtung (1) nach einem der vorhergehenden Ansprüche,
eine Messvorrichtung (9), die dazu konfiguriert ist, elektrische Antwortsignale (S_{R}) von dem Blitzschutzsystem zu erfassen und zu messen, wobei die Messvorrichtung (9) parallel zu der Signalquelle (6) über den einen oder die mehreren Ferritkerne (7) angeordnet ist, und
eine Steuereinheit (11), die dazu konfiguriert ist, die Funktion der Signalquelle (6) und der Messvorrichtung (9) zu steuern und die von der Messvorrichtung (9) erfassten Antwortsignale (S_{R}) zu verarbeiten.

6. Zustandsüberwachungsvorrichtung (8) nach Anspruch 5, wobei sich die Signalquelle (6), die Messvorrichtung (9) und/oder die Steuereinheit (11) physikalisch in einem Turm (15), einer Nabe (3), einer Gondel (16) oder einem Rotorblatt (2) der Windenergieanlage (13) befinden und ein Kabel, bevorzugt ein Koaxialkabel (12), zum Verbinden der Signalquelle (6) und/oder der Messvorrichtung (9) über den einen oder die mehreren Ferritkerne (7) verwendet wird.

7. Zustandsüberwachungsvorrichtung (8) nach Anspruch 5 oder 6, wobei die Steuereinheit (11) dazu konfiguriert ist, mit mindestens einer, insbesondere entfernten, Datenspeicher- und Analysevorrichtung zu kommunizieren.

8. Zustandsüberwachungssystem zum Überwachen des Zustands eines Blitzschutzsystems eines oder mehrerer Teile einer Windenergieanlage (13), wobei das System Folgendes umfasst;
eine oder mehrere Zustandsüberwachungsvorrichtungen (8) nach einem der Ansprüche 5-7 und
eine oder mehrere, insbesondere entfernte, Datenspeicher- und Analysevorrichtungen, die dazu konfiguriert sind, mit der/den Steuereinheit(en) (11) der einen oder der mehreren Zustandsüberwachungsvorrichtungen (8) zu kommunizieren, um Prüfsignale (S_{P}) und/oder Antwortsignale (S_{R}) zu empfangen und zu speichern und/oder zu analysieren.

9. Windenergieanlage (13), die eine oder mehrere Signaleinspeisungsvorrichtungen (1) nach einem der Ansprüche 1-4, eine oder mehrere Zustandsüberwachungsvorrichtungen (8) nach einem der Ansprüche 5-7 und/oder ein Zustandsüberwachungssystem nach Anspruch 8 umfasst.

10. Verfahren zum Einspeisen von elektrischen Prüfsignalen (S_{P}) mit variabler Frequenz in ein Blitzschutzsystem einer Windenergieanlage (13) oder eines Teils davon, ohne das Blitzschutzsystem von einem Haupterdungspfad (5), der das Blitzschutzsystem galvanisch mit der Erde verbindet, zu trennen, wobei das Verfahren die folgenden Schritte umfasst:
a) Anordnen eines oder mehrerer Ferritkerne (7) um eine Schutzeinheit, wie etwa einen Ableiter (4), des Blitzschutzsystems, um den Haupterdungspfad (5) oder an einem Verbindungspunkt zwischen der Schutzeinheit und dem Haupterdungspfad (5),
b) Verbinden einer Signalquelle (6), die dazu konfiguriert ist, die elektrischen Prüfsignale (S_{P}) zu erzeugen und in das Blitzschutzsystem einzuspeisen, über den einen oder die mehreren Ferritkerne (7) und
c) Einspeisen der erzeugten Prüfsignale (S_{P}) in eine Schaltung, die das Blitzschutzsystem und mindestens einen Teil des Haupterdungspfades (5) umfasst, mittels der Signalquelle (6).

11. Verfahren nach Anspruch 10, wobei das Verfahren unter Verwendung einer Signaleinspeisungsvorrichtung (1) nach einem der Ansprüche 1-4 durchgeführt wird.

12. Verfahren zum Überwachen des Zustands eines Blitzschutzsystems einer Windenergieanlage (13) oder eines Teils davon unter Verwendung einer oder mehrerer Zustandsüberwachungsvorrichtungen (8) nach einem der Ansprüche 5-7 oder eines Zustandsüberwachungssystems nach Anspruch 8, wobei das Verfahren die folgenden Schritte umfasst:
i) Einspeisen von elektrischen Prüfsignalen (S_{P}) mit variabler Frequenz in das Blitzschutzsystem unter Verwendung des Verfahrens nach Anspruch 11 und
ii) Messen elektrischer Antwortsignale (S_{R}) aus der Schaltung mittels der Messvorrichtung (9).

13. Verfahren nach Anspruch 12, das ferner einen Schritt des Speicherns und des Analysierens der Prüfsignale (S_{P}) und der Antwortsignale (S_{R}) umfasst, wobei die Analyse bevorzugt auf einer Änderung der Impedanz der Schaltung basiert.

14. Verfahren nach Anspruch 12 oder 13, wobei die Schaltung das/die Blitzschutzsystem(e) von einem oder mehreren Windenergieanlagenrotorblatt/-blättern (2) und mindestens einen Teil des Haupterdungspfads (5) umfasst, einschließlich einer leitenden Turmeinheit (14), die mindestens teilweise durch einen äußeren Teil eines Turms (15) der Windenergieanlage (13) gebildet wird.

15. Verfahren nach Anspruch 14, wobei die eine oder die mehreren Zustandsüberwachungsvorrichtungen (8) dazu konfiguriert sind, die Schritte i) und ii) während eines Betriebs der Windenergieanlage (13), insbesondere kontinuierlich, durchzuführen, und/oder wobei die Schritte i) und/oder ii) jedes Mal oder in regelmäßigen Abständen durchgeführt werden, wenn ein Windenergieanlagenrotorblatt (2), dessen Blitzschutzsystem durch die jeweilige Zustandsüberwachungsvorrichtung (8) überwacht wird, mit dem Turm (15) ausgerichtet ist.

## Revendications

1. Dispositif d'injection de signaux (1) permettant d'injecter des signaux de sonde électrique à fréquence variable (Sₚ) dans le système de protection contre la foudre d'une éolienne (13) ou d'une partie de celle-ci, sans déconnecter le système de protection de mise à la terre principale (5) reliant galvaniquement le système à la terre, le dispositif d'injection de signaux (1) comprend
un ou plusieurs noyaux de ferrite (7) disposés autour d'une unité de protection, telle qu'un conducteur de descente (4), du système de protection contre la foudre, autour du chemin de mise à la terre principal (5) ou à un point de connexion entre l'unité de protection et le chemin de mise à la terre principal (5), et
une source de signaux (6) configurée pour générer et injecter des signaux de sonde électrique à fréquence variable (Sₚ) dans le système de protection contre la foudre, la source de signaux (6) étant connectée à travers les un ou plusieurs noyaux de ferrite (7).

2. Dispositif d'injection de signaux (1) selon la revendication 1, dans lequel chacun des signaux de sonde (Sₚ) est constitué d'une impulsion unique ou d'un train d'impulsions, telles que des impulsions carrées, gaussiennes ou de Dirac, dont le gradient maximal est compris entre 10 mV/ns et 1 000 V/ns, préférablement entre 100 mV/ns et 100 V/ns, le plus préférablement entre 1 V/ns et 10 V/ns.

3. Dispositif d'injection de signaux (1) selon la revendication 2, dans lequel chacun des signaux de sonde (Sₚ) est constitué d'un train d'impulsions dont l'intervalle de répétition est compris entre 100 ns et 10000 ns, préférablement entre 500 ns et 2000 ns.

4. Dispositif d'injection de signaux (1) selon l'une quelconque des revendications précédentes, dans lequel les amplitudes de courant et de tension des signaux de sonde (S_{P}) sont respectivement comprises entre 0 A et 5 A et/ou entre 0 V et 50 V.

5. Dispositif de surveillance d'état (8) pour surveiller l'état d'un système de protection contre la foudre d'une éolienne (13) ou d'une partie de celle-ci, ledit dispositif de surveillance d'état (8) comprenant
un dispositif d'injection de signaux (1) selon l'une quelconque des revendications précédentes,
un dispositif de mesure (9) configuré pour détecter et mesurer les signaux de réponse électriques (S_{R}) du système de protection contre la foudre, le dispositif de mesure (9) étant disposé en parallèle avec la source de signaux (6) sur les un ou plusieurs noyaux de ferrite (7), et
une unité de commande (11) configurée pour contrôler le fonctionnement de la source de signaux (6) et du dispositif de mesure (9) et pour traiter les signaux de réponse (S_{R}) détectés par le dispositif de mesure (9).

6. Dispositif de surveillance d'état (8) selon la revendication 5, dans lequel la source de signaux (6), le dispositif de mesure (9) et/ou l'unité de commande (11) sont physiquement situés dans une tour (15), un moyeu (3), une nacelle (16) ou une pale (2) de l'éolienne (13), et un câble, de préférence un câble coaxial (12), est utilisé pour connecter la source de signaux (6) et/ou le dispositif de mesure (9) à travers les un ou plusieurs noyaux de ferrite (7).

7. Dispositif de surveillance d'état (8) selon la revendication 5 ou 6, dans lequel l'unité de commande (11) est configurée pour communiquer avec au moins un dispositif de stockage et d'analyse de données, notamment distant.

8. Système de surveillance d'état pour surveiller l'état d'un système de protection contre la foudre d'une ou plusieurs parties d'une éolienne (13), ledit système comprenant
un ou plusieurs dispositifs de surveillance d'état (8) selon l'une quelconque des revendications 5 à 7 et
un ou plusieurs dispositifs de stockage et d'analyse de données, notamment distants, configurés pour communiquer avec le ou les unités de commande (11) des un ou plusieurs dispositifs de surveillance d'état (8) afin de recevoir, stocker et/ou analyser les signaux de sonde (S_{P}) et/ou les signaux de réponse (S_{R}).

9. Éolienne (13) comprenant un ou plusieurs dispositifs d'injection de signaux (1) selon l'une quelconque des revendications 1 à 4, un ou plusieurs dispositifs de surveillance d'état (8) selon l'une quelconque des revendications 5 à 7 et/ou un système de surveillance d'état selon la revendication 8.

10. Procédé d'injection de signaux de sonde électrique à fréquence variable (S_{P}) dans un système de protection contre la foudre d'une éolienne (13) ou d'une partie de celle-ci, sans déconnecter le système de protection contre la foudre d'un chemin de mise à la terre principal (5) reliant galvaniquement le système de protection contre la foudre à la terre, ledit procédé comprend les étapes suivantes :
a) la disposition d'un ou plusieurs noyaux de ferrite (7) autour d'une unité de protection, telle qu'un conducteur de descente (4), du système de protection contre la foudre, autour du chemin de mise à la terre principal (5) ou à un point de connexion entre l'unité de protection et le chemin de mise à la terre principal (5) ;
b) la connexion d'une source de signaux (6), configurée pour générer et injecter les signaux de sonde électrique (S_{P}) dans le système de protection contre la foudre, à travers les un ou plusieurs noyaux de ferrite (7), et
c) l'injection des signaux de sonde (S_{P}) générés dans un circuit comprenant le système de protection contre la foudre et au moins une partie du chemin de mise à la terre principal (5) au moyen de la source de signaux (6).

11. Procédé selon la revendication 10, mis en œuvre à l'aide d'un dispositif d'injection de signaux (1) selon l'une quelconque des revendications 1 à 4.

12. Procédé de surveillance de l'état d'un système de protection contre la foudre d'une éolienne (13) ou d'une partie de celui-ci au moyen d'un ou plusieurs dispositifs de surveillance d'état (8) selon l'une quelconque des revendications 5 à 8, ledit procédé comprenant les étapes suivantes :
i) l'injection de signaux de sonde électriques à fréquence variable (S_{P}) dans le système de protection contre la foudre au moyen du procédé selon la revendication 11 ;
ii) la mesure de signaux de réponse électrique (S_{R}) du circuit au moyen du dispositif de mesure (9).

13. Procédé selon la revendication 12, comprenant en outre une étape de stockage et d'analyse des signaux de sonde (S_{P}) et des signaux de réponse (S_{R}), l'analyse étant de préférence basée sur une variation d'impédance du circuit.

14. Procédé selon la revendication 12 ou 13, dans lequel le circuit comprend le ou les systèmes de protection contre la foudre d'une ou plusieurs pales d'éolienne (2) et au moins une partie du chemin de mise à la terre principal (5) comprenant une unité de tour conductrice (14) formée au moins en partie par une partie extérieure d'une tour (15) de l'éolienne (13).

15. Procédé selon la revendication 14, dans lequel les un ou plusieurs dispositifs de surveillance d'état (8) sont configurés pour exécuter les étapes i) et ii) pendant le fonctionnement de l'éolienne (13), en particulier en continu, et/ou dans lequel les étapes i) et/ou ii) sont exécutées à chaque fois ou à intervalles réguliers, lorsqu'une pale d'éolienne (2), dont le système de protection contre la foudre est surveillé par le dispositif de surveillance d'état respectif (8), est alignée avec la tour (15).
